# FASCICULE DE BREVET EUROPEEN

(11) **EP 0 382 621 B1**
(45) Date de publication et mention de la délivrance du brevet: **27.05.1998**
(21) Numéro de dépôt: 90400312.6
(22) Date de dépôt: 05.02.1990
(51) Int. Cl.: H01L 21/56

(54) **Procédé d'enrobage d'un circuit intégré sur un support, dispositif pour la mise en oeuvre et ensemble électronique obtenu par la mise en oeuvre du procédé**
Verfahren zur Einkapselung einer integrierten Schaltung auf einem Träger, Anordnung zur Benutzung dieses Verfahrens und eine nach diesem Verfahren hergestellte elektronische Anordnung
Process for the encapsulation of an integrated circuit on a support, device for carrying out this method and electronic assembly obtained by this process

(30) Priorité: 06.02.1989 FR 8901474
(43) Date de publication de la demande: 16.08.1990
(73) Titulaire: CP8 Transac, 78430 Louveciennes (FR)
(72) Inventeur: Dufour, Michel, F-78230 Le Pecq (FR); Carpier, Roland, F-78180 Monti (FR); Lallemand, Yves, F-95100 Argenteuil (FR)
(74) Mandataire: Corlu, Bernard

(56) Documents cités:
- PATENT ABSTRACTS OF JAPAN vol. 9, no. 295 (E-360)(2018) 21 novembre 1985, & JP- A-60 134447 (ROOMU K.K.) 17 juillet 1985,
- PATENT ABSTRACTS OF JAPAN vol. 8, no. 221 (E-271)(1658) 09 octobre 1984, & JP- A-59 105342 (ROOMU K.K) 18 juin 1984,
- PATENT ABSTRACTS OF JAPAN vol. 11, no. 7 (E-469)(2454) 09 janvier 1987, & JP-A- 61 184834 (TOSHIBA CHEM. CORP) 18 août 1986,

## Description

L'invention est relative à un procédé d'enrobage d'un circuit intégré sur un support, et à un dispositif pour la mise en oeuvre de ce procédé.

On connaît des ensembles électroniques qui incorporent au moins un circuit intégré porté par un support tel qu'un circuit imprimé permettant l'interconnexion électrique entre le circuit intégré et d'autres ensembles électroniques, de façon à constituer un système en état de fonctionnement. Par circuit intégré, on entend un dispositif remplissant des fonctions électroniques prédéterminées, plus ou moins complexes, et constitué à partir d'une barrette de matériau semi-conducteur, de dimensions réduites, qui, dans de nombreuses applications, est encore appelé puce ou chip. Les fonctions prédéterminées réalisées par une puce peuvent être relativement simples, telles que la fonction amplification, ou plus complexes, puisque selon le degré d'intégration une simple puce peut constituer à elle seule un microprocesseur complet avec ses mémoires de travail ou de programme.

Un circuit intégré constitue donc un circuit électronique dont certains points, appelés encore bornes, doivent être interconnectés avec l'extérieur. A cet effet, des fils conducteurs de section très réduite relient les bornes au reste du système électronique.

Dans de multiples applications, l'ensemble constitué par la puce et les fils est enfermé dans un boîtier d'où sortent des pattes de connexion avec l'extérieur. Une première extrémité de chacun des fils est reliée à une borne du circuit intégré, et l'autre extrémité est reliée à une patte déterminée du boîtier, de sorte que lorsque le boîtier est monté sur un circuit imprimé, alors le dispositif électronique peut remplir ses fonctions. Un système électronique peut comprendre plusieurs circuits imprimés, portant chacun plusieurs boîtiers et/ou autres composants.

Dans d'autres applications, il n'est pas possible, pour des raisons d'encombrement, d'utiliser des circuits intégrés ou puces enfermés dans un boîtier. C'est par exemple le cas des circuits intégrés utilisés dans les cartes à microcircuits électroniques, encore connues sous l'appellation de cartes à puce ou cartes à mémoire, selon la fonction remplie par le microcircuit. Ces cartes sont utilisées dans des systèmes de traitement confidentiel de données, par exemple dans le domaine bancaire, téléphonique ou autres.

Dans un tel cas, le circuit intégré est fixé sur une face d'un support qui porte, sur son autre face, des plages de contact avec l'extérieur. Les fils du circuit intégré sont connectés aux plages de contact du support, qui constitue alors un circuit imprimé, et l'ensemble ainsi formé est placé dans une cavité d'une feuille en matériau souple qui constitue le corps de la carte, le circuit intégré se trouvant emprisonné à l'intérieur du corps, et les plages de contact étant au niveau de l'une des grandes faces du corps de la carte.

Dans un tel cas, afin de protéger le circuit intégré, bien que l'on ne puisse utiliser un boîtier, il est usuel, avant de placer le circuit intégré et son circuit imprimé de support dans le corps de la carte, d'enrober le circuit intégré et les fils de connexion aux plages de contact du circuit imprimé dans un matériau tel qu'une résine de protection.

L'enrobage permet de protéger la puce et les fils lors des manipulations ultérieures, notamment pendant la phase de mise en place dans le corps de la carte. En effet, une puce possède une surface de quelques millimètres carrés et une épaisseur mesurée en microns, de 350 microns en moyenne, ce qui correspond à des valeurs extrêmes comprises entre 100 et 500 microns en moyenne, et de ce fait est relativement fragile. Il faut donc éviter sa détérioration physique, qui la rend inutilisable, et également le contact avec des micro-poussières ou particules qui viendrait modifier le comportement électronique du circuit. Il faut noter, à ce stade, que le rôle d'un boîtier dans les applications précédemment décrites est similaire.

Dans le cas particulier de l'application aux cartes à mémoire, les plages de contact du circuit imprimé servant de support à la puce sont mises en relation électrique avec le reste du système, par exemple grâce aux bornes d'un connecteur spécifique à la carte.

Il est bien entendu que l'on peut envisager d'autres applications où la puce n'est pas enfermée dans un boîtier, par exemple des applications dans lesquelles pour augmenter le nombre de circuits intégrés portés par un simple circuit imprimé, on utilise des circuits sans boîtier. En effet, lorsqu'un circuit intégré est enfermé dans un boîtier, il faut savoir que le volume du boîtier occupe quelques millimètres cubes, alors que la puce occupe quelques centièmes de millimètres cubes, et il en résulte que les dimensions du boîtier sont disproportionnées par rapport aux dimensions de la puce. Ces dimensions disproportionnées sont nécessaires pour permettre que les pattes de contact fixées au boîtier soient de dimension suffisante pour avoir une bonne régidité, notamment lors des manipulations.

Ainsi, dans certaines applications, afin que d'une part la puce et les fils soient protégés vis-à-vis des agressions extérieures et ne détériorent pas, et que d'autre part une isolation électrique soit assurée, il est connu d'enrober l'ensemble constitué par la puce et les fils dans de la résine ou dans un autre matériau isolant. Par ailleurs, l'enrobage améliore ou assure le maintien de la puce sur son support.

Un premier procédé connu d'enrobage consiste à pulvériser sur l'ensemble constitué par la puce et les fils, un matériau d'enrobage polymérisable à température ambiante.

Ce procédé présente les inconvénients suivants : d'une part, il ne permet pas de contrôler facilement la forme et l'épaisseur de l'enrobage, et d'autre part, les fils conducteurs partant de la puce se comportent comme un filet qui empêche une bonne diffusion du matériau, de sorte qu'il peut arriver qu'une partie de la puce ou des fils ne soit pas enrobée, ou bien qu'en raison de l'effet de filet, des bulles d'air subsistent dans l'enrobage, d'où il en résulte une faiblesse mécanique et/ou une mauvaise protection.

Un autre procédé permet de contrôler la forme de l'enrobage. Il consiste à réaliser l'enrobage par moulage transfert ; à cet effet, un moule ayant la forme finale désirée de l'enrobage, dans lequel débouche au moins un canal d'injection du produit d'enrobage, est placé au contact du support, en enfermant totalement la puce et les fils, de façon à délimiter le volume à enrober, et le produit d'enrobage est injecté à l'intérieur du moule par le canal d'injection, avant d'être durci, par exemple par polymérisation à froid ou à chaud.

Ce procédé, s'il présente l'avantage de permettre d'obtenir un enrobage de forme finie, présente cependant d'autres inconvénients. D'une part, il nécessite la réalisation d'un dispositif assez complexe et coûteux, car les volumes de produit à injecter sont très faibles, de l'ordre de quelques millimètres cubes, et il faut réaliser un usinage très précis du moule, avec de faibles tolérances, de même qu'il faut réaliser des canaux d'injection de très petite section. Par ailleurs, le produit est injecté à l'état liquide ou solide ou semi-solide, de sorte qu'afin de remplir correctement la cavité du moule, l'injection nécessite une certaine pression ; il peut arriver que le produit injecté, en raison de sa vitesse de pénétration dans la cavité, déplace le circuit intégré et/ou les fils, détériorant alors l'ensemble électronique à enrober. En conséquence, l'ensemble enrobé est inutilisable, même si l'enrobage possède la forme et les dimensions souhaitées.

En outre, la présence d'un canal d'injection implique une maintenance particulière, puisque la section du canal est de section très réduite, de l'ordre de quelques centièmes de millimètres carrés, et il faut prévoir un contrôle régulier de ce canal pour éviter qu'il soit obstrué. Il en résulte que, globalement, ce procédé ne permet pas d'obtenir un enrobage correct en toutes circonstances, et par ailleurs son dispositif de mise en oeuvre nécessite des opérations particulières de maintenance et d'entretien.

Le document Patent Abstracts of Japan vol.9, N°295, 21 Nov. 1985 enseigne un cadre entourant le circuit intégré à enrober, dans lequel est versé le matériau d'enrobage à l'état fluide, ce cadre étant ensuite retiré après durcissement du matériau d'enrobage (voir le préambule des revendications 1 et 7). Ce procédé donne satisfaction tant que la hauteur du cadre est voisine de celle du circuit intégré à enrober. En revanche, lorsque cette hauteur est choisie sensiblement supérieure à celle du circuit intégré, en vue notamment de conférer une rigidité plus importante au cadre pour appliquer celui-ci plus intimement sur le support de circuit intégré, un phénomène de remontée du matériau d'enrobage par capillarité le long de la paroi intérieure du cadre est observé, qui provoque un mauvais recouvrement du circuit intégré.

La présente invention vise à permettre l'utilisation d'un cadre sans provoquer l'inconvénient précité, et concerne à cet effet un procédé d'enrobage selon la partie caractérisante de la revendication 1 et un dispositif d'enrobage selon la partie caractérisante de la revendication 7.

La Demanderesse a constaté que la présence du palier empêchait efficacement le matériau d'enrobage de remonter le long de la paroi intérieure du cadre.

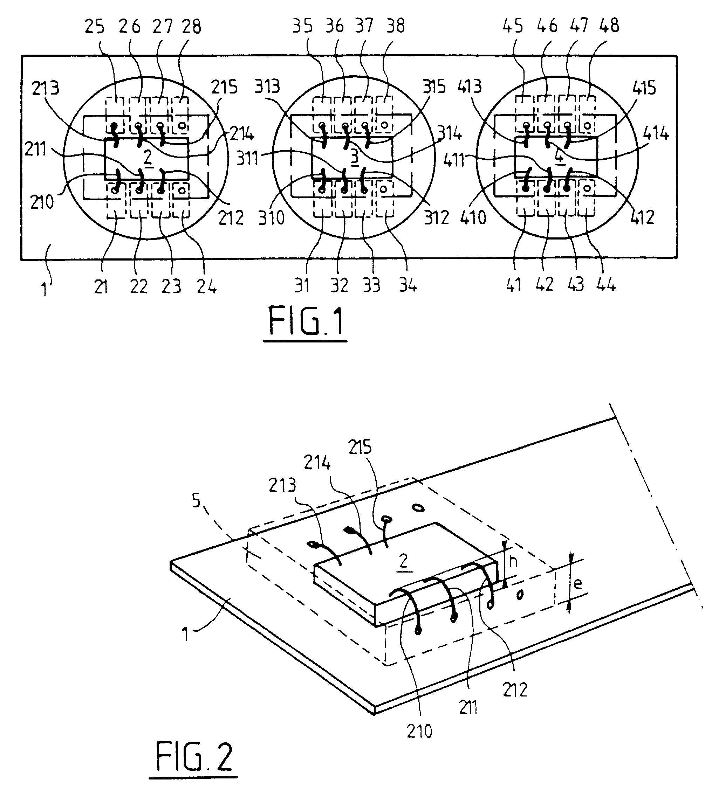

D'autres caractéristiques et avantages de l'invention apparaîtront avec la description qui va suivre, faite en regard des figures 1 à 9F annexées, illustrant de façon non limitative divers dispositifs de mise en oeuvre de l'invention et/ou divers ensembles électroniques auxquels l'invention est applicable.

La figure 1 illustre un ruban constituant un support 1 qui porte sur l'une de ces faces plusieurs circuits intégrés 2, 3, 4 destinés chacun à constituer l'élément électronique actif d'une carte à microcircuits électroniques. L'autre face du ruban porte, sensiblement en regard de chacun des circuits intégrés 2, 3, 4, des plages de contact (21, 22 ... 27, 28, 31, 32 ... 37, 38, 41, 42 ... 47, 48) représentées en traits interrompus, et destinées à assurer, lorsque les cartes à microcircuits seront terminées, l'interconnexion entre les microcircuits contenus dans chacun des circuits intégrés et le reste du système utilisant les cartes à mémoire.

Certaines des plages de contact en regard d'un circuit intégré sont reliées au circuit correspondant par l'intermédiaire de fils électriques de liaison (210 ... 215, 310 ... 315, 410 ... 415). Sur cette figure, chaque circuit intégré est représenté comme ayant une forme de parallélépipède rectangle, et les fils conducteurs partent tous d'une même face de chaque circuit intégré, qui, dans l'exemple, est la face du circuit opposée à celle par laquelle ils sont en contact avec le ruban porteur. Il est bien entendu que cette figure a un rôle purement illustratif et que les fils conducteurs peuvent partir d'autres endroits de chacun des circuits intégrés, et en particulier des côtés, ou bien sur la face de chaque circuit intégré en contact avec le ruban porteur 1.

La liaison entre un fil conducteur et la plage correspondante située sur l'autre face du ruban est assurée de façon connue en soi, soit grâce à un trou métallisé perçé au travers du ruban, ou par tout autre moyen approprié déjà connu dans le domaine.

Autour de chaque circuit intégré, 2, 3, 4, et des plages de contact correspondant à chacun, on a représenté en trait plein un secteur circulaire qui visualise, à titre illustratif et non limitatif, l'emplacement d'une découpe qui sera réalisée après que l'enrobage aura été terminé, afin de séparer du ruban chacun des ensembles électroniques constitués par un circuit intégré, ses plages de contact, et les fils de liaison entre le circuit et lesdites plages, un ensemble ainsi séparé du ruban constituant ce qui est couramment appelé un bouton qui est placé dans une cavité de la carte à microcircuits.

La réalisation d'une carte complète ne rentre pas dans le cadre de la présente invention, d'autant plus que le procédé est applicable à l'enrobage de circuits destinés à toutes applications connues ou envisageables, autres que les cartes.

De plus, sur la figure 1, à l'intérieur de chacun des secteurs circulaires, on a représenté en trait mixte un cadre qui entoure le circuit intégré et les fils conducteurs correspondants. Ce cadre en trait mixte représente l'emplacement de l'enrobage sur la face du ruban portant les circuits intégrés.

Dans l'exemple, la section de l'enrobage est rectangulaire. Il est bien entendu que ceci n'est pas limitatif, et que la section de l'enrobage au niveau du ruban peut être de toute autre forme, par exemple carrée, circulaire, ovale, carrée ou rectangulaire avec des coins arrondis ou tronqués, etc.

Par ailleurs, on le rappelle, la figure 1 illustre le cas où les circuits intégrés 2, 3, 4, sont implantés sur un ruban porteur, de façon à constituer par la suite les éléments actifs d'une carte à microcircuits. Il est bien entendu que cet exemple n'est pas limitatif, et qu'en particulier les circuits intégrés peuvent être implantés sur un circuit imprimé plus complexe qui, au lieu de comporter de simples plages de contact pour l'interconnexion avec l'extérieur, peut également comporter des bandes conductrices permettant une liaison de plusieurs circuits intégrés ainsi constitués entre eux, ou bien la liaison entre un ou plusieurs circuits intégrés et d'autres éléments électroniques actifs ou passifs, le circuit n'étant pas, dans ce cas, nécessairement destiné à une carte.

En outre, dans l'exemple illustré, les plages conductrices sont placées sur la seconde face du ruban porteur 1, c'est-à-dire celle opposée à la face portant les circuits intégrés 2, 3, 4, et les fils conducteurs correspondants. Il est bien entendu possible de concevoir des dispositifs dans lesquels un circuit intégré et ses fils conducteurs sont portés sur la face d'un support portant également des bandes ou plages conductrices.

Enfin, sur la figure 1 on a illustré un ruban portant trois circuits intégrés. Là encore, il faut noter que le procédé de l'invention peut s'appliquer à l'enrobage d'un nombre supérieur ou inférieur de circuits intégrés portés par un même support, et dont l'emplacement et/ou la forme peut par ailleurs être très variable. En effet, ici les circuits intégrés sont alignés sur un même axe longitudinal du ruban, mais il peut être envisagé des cas où les circuits ne sont pas portés par le même axe ni disposés dans le même sens. C'est par exemple le cas lorsque le support constitue un circuit imprimé plus complexe, de sorte que différents circuits intégrés associés entre eux grâce à ce circuit imprimé plus complexe constituent un ensemble électronique cumulant et/ou combinant les fonctions de chacun des circuits intégrés qu'il porte. Dans ce cas, un dispositif pour la mise en oeuvre du procédé de l'invention sera réalisé de façon à permettre l'enrobage des circuits intégrés un par un, ou simultanément, comme il sera expliqué plus loin.

Sur la figure 2, on a illustré, en perspective, une partie des éléments de la figure 1, à savoir, une partie du ruban porteur 1, et l'un des circuits intégrés 2, ses fils de connexion 210, 211 ... 214, 215, avec les plages de contact non représentées cette fois-ci et situées sur l'autre face du ruban ou support 1. Cette figure permet de montrer que dans l'exemple, les fils conducteurs partent de la face du circuit intégré opposée à celle qui est disposée sur le support 1. En traits interrompus, on a représenté une forme possible finale pour l'enrobage 5 d'un tel ensemble électronique constitué par la puce et ses fils conducteurs associés. On constate que si l'épaisseur de l'ensemble électronique prise entre la face du support 1 sur laquelle il est posé et son ou ses points les plus éloignés par rapport à cette face a une valeur donnée "h", alors l'épaisseur totale "e" de l'enrobage et sa forme doivent être telles que la totalité de l'ensemble électronique défini précédemment doit se trouver prise dans l'enrobage. Ainsi, dans l'exemple illustré l'enrobage a une forme parallélépipèdique, et il en résulte que son épaisseur "e" doit être supérieure à l'épaisseur "h" de l'ensemble électronique et que sa section doit être supérieure à la projection orthogonale de l'ensemble électronique sur ladite face de support.

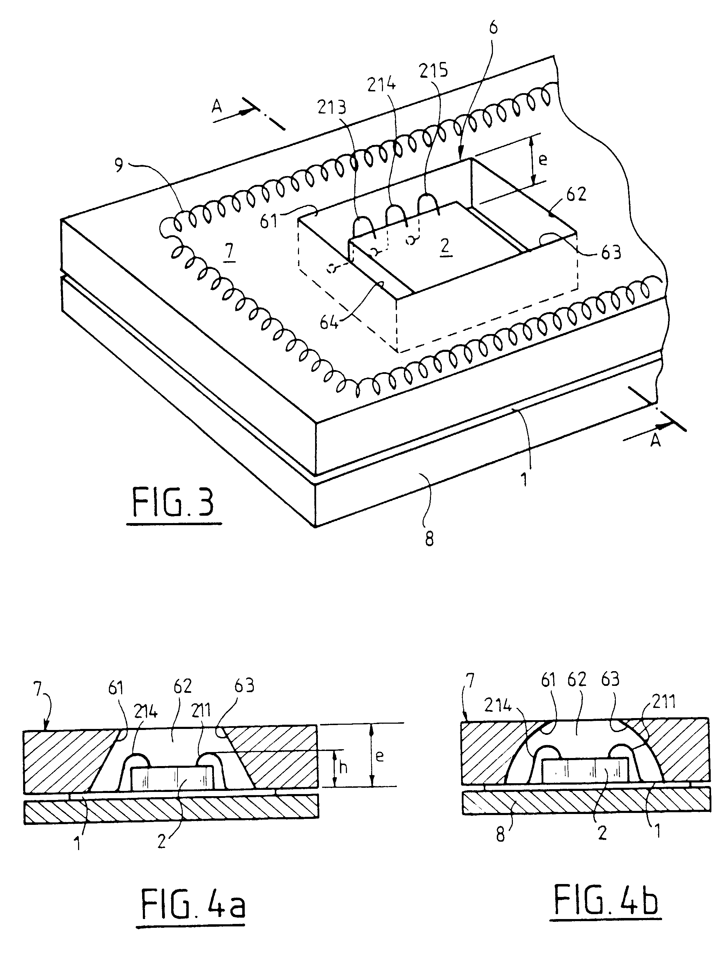

La figure 3 illustre le principe d'un dispositif de mise en oeuvre du procédé de l'invention permettant l'enrobage unitaire d'ensembles électroniques.

Un cadre 6 est constitué dans un bloc ou barrette 7 en matériau approprié pour recevoir le matériau d'enrobage sans être détérioré. Le cadre 6 est réalisé de façon à pouvoir être posé sur la face du support 1 portant le circuit intégré 2 et les fils de contact 210, 211 ... 214, 215 de ce dernier avec l'extérieur.

Dans la suite de la description, l'expression "hauteur" ou "épaisseur" de l'ensemble électronique doit être comprise comme étant la dimension séparant le plan du support 1 portant l'ensemble électronique et le plan parallèle au dit plan du support, le plus éloigné de ce dernier, ayant au moins un point commun avec un élément de l'ensemble électronique. Ainsi, dans l'exemple illustré, on constate que les fils conducteurs partent de la face du circuit intégré 2 opposée à sa face portée par le support 1, de sorte que la hauteur de l'ensemble électronique est la distance qui sépare ladite face du support 1 du point le plus éloigné des conducteurs par rapport à ladite face du support.

Par extension, la hauteur ou épaisseur de l'enrobage est la dimension de l'enrobage prise à partir du support dans un sens normal à ce dernier, et enfin la hauteur, ou épaisseur, ou profondeur, du cadre 6 est déterminée à partir du plan commun au support et au cadre.

Comme il apparaît sur la figure 3, le cadre est posé sur le support de façon à entourer l'ensemble électronique à enrober et, conformément à la présente invention, avant de placer le matériau d'enrobage dans le cadre 6, d'une part le support 1 est positionné de façon telle que sa face portant l'ensemble électronique à enrober soit horizontale, et que le cadre soit accessible par-dessus ce plan horizontal. Par ailleurs, avant de placer le matériau d'enrobage à l'intérieur du cadre, il est prévu d'exercer une pression suffisante entre le cadre 6 et le support 1 pour qu'une étanchéité soit assurée, afin d'éviter que le matériau d'enrobage, lorsqu'il se trouvera à son état liquide, ne puisse se diffuser à l'extérieur du cadre entre les rebords de celui-ci et le support.

Le fait de positionner le support dans un plan horizontal avec l'ensemble électronique 2 et les conducteurs par-dessus permet que le matériau d'enrobage se répartisse, lorsqu'il est à l'état liquide, par gravité à l'intérieur du cadre, de façon à entourer totalement et correctement l'ensemble électronique, et que par capillarité il se répande dans la totalité du cadre.

Généralement le support 1 est constitué dans un matériau possédant une relative souplesse (par exemple du verre époxy), de sorte que dans un mode de mise en oeuvre préféré du procédé de l'invention, on prévoit de poser le support 1 sur un socle 8 de maintien, et on enserre le support 1 entre le socle et le cadre de façon à assurer l'étanchéité entre le cadre et le support.

Comme il a été expliqué dans le préambule de la présente demande, le matériau d'enrobage peut être thermo-durcissable ou polymérisable à chaud ou bien un matériau déposé à l'état liquide et qui se durcit ou se polymérise à température ambiante.

Dans tous les cas, il faut choisir pour réaliser le cadre un matériau qui ne peut pas adhérer avec le matériau d'enrobage, et il faut constituer le cadre de façon que lorsque le matériau d'enrobage aura durci ou aura été polymérisé, aucun élément du cadre ne puisse faire saillie dans la masse du matériau d'enrobage entraînant une détérioration de ce dernier lors du retrait du cadre. C'est pourquoi, le cadre est constitué de façon telle que ses rebords soient perpendiculaires au plan du support, déterminant alors un enrobage parallélépipèdique rectangle, comme illustré par la figure 3, ou bien encore que la section de l'ouverture du cadre à sa base, c'est-à-dire à son plan de jonction avec le support 1 soit supérieure à la section de l'ouverture supérieure du cadre, c'est-à-dire l'ouverture par laquelle est introduit le matériau d'enrobage, de sorte que la section du cadre est plus faible à son sommet qu'à sa base. Ceci est illustré par les figures 4A et 4B qui montrent en coupe AA de la figure 3, deux rebords opposés 61, 63, du cadre qui convergent de deux façons différentes. Dans le cas de la figure 4A, les rebords 61, 63 sont de forme plane et convergent l'un vers l'autre de sorte que la section de l'ouverture du cadre se réduit uniformément entre la base et le sommet, alors que dans le cas de la figure 4B, lesdits rebords 61 et 63 sont incurvés, de façon à converger vers le sommet du cadre.

Dans le cas où le matériau d'enrobage utilisé est une résine ou un matériau thermo-durcissable ou polymérisable à chaud, le dispositif de mise en oeuvre, et en particulier le matériau constitutif de la barrette comportant le ou les cadres sera différent selon les moyens utilisés pour porter le matériau d'enrobage à sa température de durcissement.

En effet, comme il a été expliqué dans le préambule de la présente demande, il est possible d'envisager un chauffage direct, en présentant le matériau d'enrobage à une source de rayonnement appropriée. Dans ce cas, la source de rayonnement est placée au-dessus de l'ouverture du cadre par laquelle le matériau d'enrobage est introduit et, dans ce cas, de préférence, le matériau constitutif de la barrette comportant le ou les cadres est un matériau isolant pour éviter les déperditions d'énergie dans sa masse. Ainsi, dans un tel cas, on peut choisir de réaliser la barrette dans un matériau céramique.

Lorsque ce mode de chauffage est mis en oeuvre et que la barrette 7 comporte plusieurs cadres pour réaliser l'enrobage simultané de plusieurs ensembles électroniques, le dispositif de chauffage peut comporter une seule source de rayonnement qui se déplace relativement en regard de chaque cadre, ou bien encore plusieurs sources de rayonnement, par exemple une en face de chaque cadre, pour que le durcissement de plusieurs enrobages puisse avoir lieu simultanément.

Dans une variante, le matériau d'enrobage est porté à sa température de durcissement en apportant l'énergie par l'intermédiaire du matériau constitutif de la barrette 7. Dans un tel cas, il faut que ce matériau soit un bon conducteur de la chaleur, et on choisit soit un alliage, soit un métal résistant à la température de polymérisation ou de durcissement. Dans ce cas, la température nécessaire au niveau du cadre peut être obtenue soit en soumettant directement la barrette à une source de rayonnement, la diffusion étant assurée ensuite à l'intérieur de la masse de la barrette portant le ou les cadres grâce à ses propriétés conductrices, ou bien encore en utilisant des éléments chauffants disposés à l'intérieur de la masse de la barrette. Ces éléments chauffants sont symbolisés par la spirale 9, inclue dans la masse de la barrette 7 sur la figure 3.

Dans une autre variante, on cumule le chauffage par exposition directe du matériau d'enrobage à une source de rayonnement et par apport de chaleur par la masse de la barrette qui, dans ce cas, est alors dans un matériau conducteur.

Dans ce cas, deux possibilités sont envisageables. Une première consiste à utiliser une source de rayonnement placée en regard de la ou des ouvertures de la barrette, et qui a une puissance suffisante pour chauffer également la masse de la barrette ; une seconde consiste à placer des éléments chauffants dans la barrette et à exposer chaque ouverture à une source de rayonnement plus ponctuelle.

Enfin, il faut noter que lorsque le matériau d'enrobage choisi durcit ou polymérise à température ambiante, il importe peu que le matériau constitutif de la barrette soit isolant ou conducteur.

La façon dont le matériau d'enrobage est mis en place sera expliquée ultérieurement car elle s'applique également aux variantes illustrées en regard des figures suivantes.

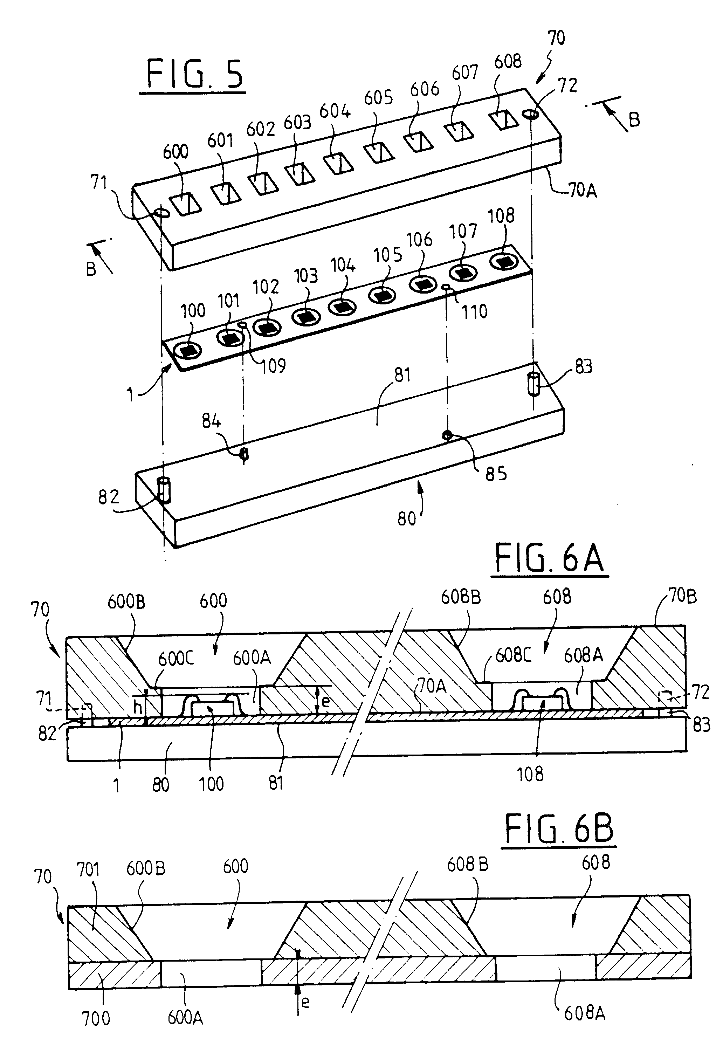

La figure 5 illustre un dispositif pour la mise en oeuvre du procédé de l'invention, applicable à l'enrobage simultané d'un nombre non unitaire d'ensembles électroniques constitués chacun par un circuit intégré et par un certain nombre de fils conducteurs pour la liaison entre le circuit intégré et l'extérieur. Bien entendu, le nombre, la forme et la répartition des ensembles peuvent être différents, comme il a été décrit précédemment.

Le dispositif décrit s'applique donc particulièrement à l'enrobage d'ensembles électroniques portés par un même support 1, tel que décrit en regard de la figure 1.

Le dispositif est constitué de la façon suivante : une barrette 70 est traversée de part en part, dans le sens de son épaisseur, d'un nombre déterminé d'ouvertures, 600, 601 ... 607, 608 dont chacune comporte un cadre pour l'enrobage des ensembles électroniques 100, 101, 102 ... 107, 108 portés par le support 1.

On constate sur cette figure que l'épaisseur de la barrette dans laquelle sont ménagées les ouvertures est disproportionnée par rapport aux dimensions des ensembles électroniques portés par le ruban porteur. La raison de cette disproportion sera expliquée en regard de la description des figures 6A et 6B qui illustrent des vues en coupe partielle BB de deux variantes de réalisation de la barrette 70 de la figure 5, et permettent de visualiser la façon dont sont réalisées les ouvertures.

De préférence, on prévoit un socle 80 dont la face supérieure 81 est plane pour recevoir le support 1 des ensembles électroniques 100, 101 ... 107, 108. La face inférieure 70A de la barrette 70, dans laquelle sont réalisées les ouvertures, est également plane pour que le support 1 des ensembles électroniques puisse être comprimé entre ladite face inférieure de la barrette et la face supérieure du socle, lorsque le matériau d'enrobage est dans les cavités, afin qu'une étanchéité soit assurée au plan de jonction entre les cadres constitués dans la barrette 70 et la face du support 1 sur laquelle ladite face inférieure 70A de la barrette est appliquée. Il en résulte qu'aucune fuite de matériau d'enrobage ne peut avoir lieu lorsqu'il est liquide.

De préférence, des moyens sont prévus pour permettre une mise en place correcte du support 1 par rapport à la barrette 70 comportant les ouvertures 600, 601 ... 607, 608 dans lesquelles les cadres déterminant la forme de l'enrobage sont ménagés.

Dans l'exemple illustré, deux tétons 82, 83, sont prévus sur la face supérieure 61 du socle, qui viennent s'emboîter dans des orifices 71, 72 correspondants, ménagés à chaque extrémité de la barrette 70 portant les ouvertures. Par ailleurs, deux autres tétons 84, 85 sont prévus sur la face supérieure 81 du socle 80, pour venir s'introduire dans deux orifices 109, 110 correspondants réalisés dans le support 1 des ensembles électroniques 100, 101 ... 107, 108.

Ainsi, afin d'enrober une série d'ensembles portés par un même support, il suffit de positionner ledit support correctement sur le socle 80 à l'aide des tétons 84, 85 ménagés sur le socle et des orifices correspondants 109, 110 ménagés dans le support 1, puis de positionner la barrette 70 sur le socle à l'aide des tétons 82, 83 du socle 80 et des orifices correspondants 71, 72 de la barrette 70. Alors puisque le support est correctement positionné sur le socle ainsi que la barrette, il en résulte que les ensembles électroniques sont correctement positionnés par rapport aux ouvertures de ladite barrette.

D'autres moyens sont envisageables pour réaliser l'alignement, mais ils n'entrent pas dans le cadre de la présente invention. En particulier, il peut ne pas être nécessaire de positionner correctement la barrette par rapport au socle, dans la mesure où des moyens d'alignement directs sont prévus entre la barrette et le support 1 des ensembles électroniques. En effet, les tétons 84, 85 qui se trouvent, dans le cas illustré par la figure 5, sur la face supérieure 81 du socle 80 pourraient être remplacés par des tétons placés sur la face inférieure de la barrette 70.

Egalement, les moyens pour exercer la pression entre la barrette 70 et le socle 80, afin de bien emprisonner le support 1 des ensembles électroniques, n'ont pas été représentés. On peut envisager l'emploi de moyens de serrage hydrauliques, mécaniques ou autres.

La figure 6A illustre une vue partielle en coupe BB de la figure 5, montrant en particulier la forme que peuvent avoir les ouvertures ménagées dans la barrette 70. Cette figure permet également de visualiser l'emplacement relatif qu'occupent les différents éléments du dispositif lorsque ce dernier est prèt pour l'opération d'enrobage.

On constate ainsi que le support 1 portant les différents ensembles électroniques 100 ... 108 est serré entre la barrette 70 et le socle 80 et qu'une étanchéité est assurée à la périphérie des ouvertures de la barrette 70 au niveau de leur plan de jonction avec le support des ensembles électroniques .

On constate aussi sur cette figure comme sur la figure 5, que l'épaisseur totale de la barrette 70, c'est-à-dire sa dimension prise dans une direction perpendiculaire à sa face 70A destinée à être mise au contact du support 1 des ensembles électroniques, est nettement supérieure à l'épaisseur "h" desdits ensembles électroniques. Or, comme il a été exposé dans le préambule de la présente demande, l'invention s'applique à la réalisation d'enrobages de très faibles dimensions et volumes : en particulier il s'applique à l'enrobage de circuits électroniques destinés à être intégrés dans des cartes à mémoire. Or, pour de telles applications, l'épaisseur totale de l'enrobage peut être comprise entre 150 microns et 600 à 700 microns, l'ensemble électronique ayant une épaisseur de l'ordre de quelques centaines de microns. Il en résulte que le cadre servant à l'enrobage peut avoir une épaisseur ou une profondeur maximale de l'ordre de 700 microns, c'est-à-dire une épaisseur ou une profondeur correspondant à l'épaisseur maximum de l'enrobage. On conçoit très bien qu'une barrette 70 permettant l'enrobage simultané de plusieurs ensembles électroniques, en étant pourvue d'un nombre correspondant d'ouvertures, et qui aurait simplement une épaisseur "e" correspondant à l'épaisseur requise pour chaque cadre n'aurait pas une rigidité suffisante pour pouvoir être correctement plaquée sur le support, de sorte que le matériau d'enrobage, lorsqu'il se trouverait à l'état liquide diffuserait entre la barrette et le support, si l'étanchéité n'était pas assurée.

C'est pourquoi, la barrette possède une épaisseur totale nettement supérieure à celle requise pour la constitution du cadre déterminant l'épaisseur "e" et la section de chaque enrobage, afin de lui conférer une bonne rigidité pour que la pression exercée entre le support 1 et la barrette 70 soit suffisante.

Par ailleurs, chaque ouverture 600, 601 ... 608 est réalisée en deux parties distinctes 600A ... 608A et 600B ... 608B respectivement.

La partie 600A, 608A de chacune des ouvertures 600, 608 détermine le cadre nécessaire à l'enrobage. Elle est donc réalisée à partir de la face inférieure 70A de la barrette 70 destinée à venir au contact du support lors de la mise en place de l'enrobage et possède donc la forme et les dimensions du bord extérieur de l'enrobage adjacent au support 1. En particulier, cette première partie possède une profondeur "e" égale à l'épaisseur finale souhaitée pour chaque enrobage. Cette partie peut être réalisée selon l'une quelconque des variantes illustrées en regard des figures 3, 4A et 4B, c'est-à-dire qu'elle peut être réalisée de façon telle que les bords extérieurs de l'enrobage adjacents au support soient perpendiculaires à ce dernier, ou bien qu'une certaine convergence apparaîsse au fur et à mesure que l'on s'éloigne du support, pour favoriser le retrait de la barrette après le durcissement du matériau d'enrobage.

La première partie 600A, 608A s'achève dans l'épaisseur de la barrette 70 par un palier 600C, 608C parallèle à la face de la barrette destinée à venir au contact du support 1, la présence de ce palier entraînant une brusque augmentation de la section de l'ouverture dans l'épaisseur de la barrette 70, et la seconde partie 600B, 608B de chaque ouverture est comprise entre ce palier et la seconde face 70B de la barrette, opposée à celle prévue pour venir au contact du support.

Dans un mode de réalisation illustré par la figure 6A, la section de la seconde partie de cavité s'élargit entre sa partie commune avec le palier 600C, 608C, et son débouché sur la seconde face 70B de la barrette 70. Cet élargissement favorise la mise en place du matériau d'enrobage dans chaque cavité, car il faut savoir que dans de nombreuses applications, la section de l'enrobage, prise au niveau du support 1 est de quelques dizaines de millimètres carrés, ce qui correspond pour un enrobage de section carrée à la base à une arête de l'ordre de 5 millimètres ; l'élargissement de la section favorise l'entretien et le nettoyage de la barrette 70 d'une part, et surtout lors de la mise en oeuvre du procédé d'enrobage, il favorise la mise en place du matériau d'enrobage à l'intérieur de l'ouverture, puisque celle-ci est ainsi plus accessible.

Il faut par ailleurs noter, d'une façon semblable à ce qui a été décrit en regard de la description de la figure 3, que du choix du matériau d'enrobage et de son mode de durcissement ou de polymérisation dépend le choix du matériau constitutif de la barrette dans laquelle sont ménagées les différentes ouvertures.

En particulier, si le matériau est un matériau durcissable ou polymérisable à chaud, et que la polymérisation s'effectue en exposant chacune des ouvertures à une source de rayonnement approprié, tel qu'un rayonnement laser ou autre, alors il est préférable de constituer la barrette 70 dans un matériau isolant tel qu'une céramique, afin d'éviter les déperditions d'énergie dans la masse de ce matériau. Par contre, il faut choisir un matériau conducteur de la chaleur, au cas où l'on souhaite que la chaleur de la barrette soit transmise au matériau d'enrobage. Dans ce dernier cas, la chaleur peut être transmise en exposant la barrette à une source de rayonnement, ou bien en disposant des éléments chauffants dans la masse de la barrette 70.

La figure 6B illustre une variante de réalisation de la barrette 70 qui est constituée en deux éléments distincts 700, 701 qui sont superposables l'un à l'autre, avant que le matériau d'enrobage soit mis en place.

Le premier élément 700, d'épaisseur "e", égale à celle souhaitée des enrobages, comporte les ouvertures 600A ... 608A déterminant les cadres pour placer le matériau d'enrobage, et le second élément 701 sert de renfort externe, et est pourvu des ouvertures 600B ... 608B permettant l'introduction du matériau d'enrobage. La section et l'emplacement des ouvertures 600B ... 608B sont tels que lorsque les deux éléments 700, 701 sont en place l'un par rapport à l'autre, les paliers 600C ... 608C, décrits en regard de la figure 6A, sont présents.

Cette structure en deux éléments favorise le nettoyage et la maintenance du dispositif.

Les éléments chauffants, s'ils sont présents dans la masse du dispositif sont dans la première partie 700 et/ou dans la seconde partie 701, la seconde partie 701 se prêtant cependant plus facilement à leur mise en place en raison de son épaisseur supérieure à la première.

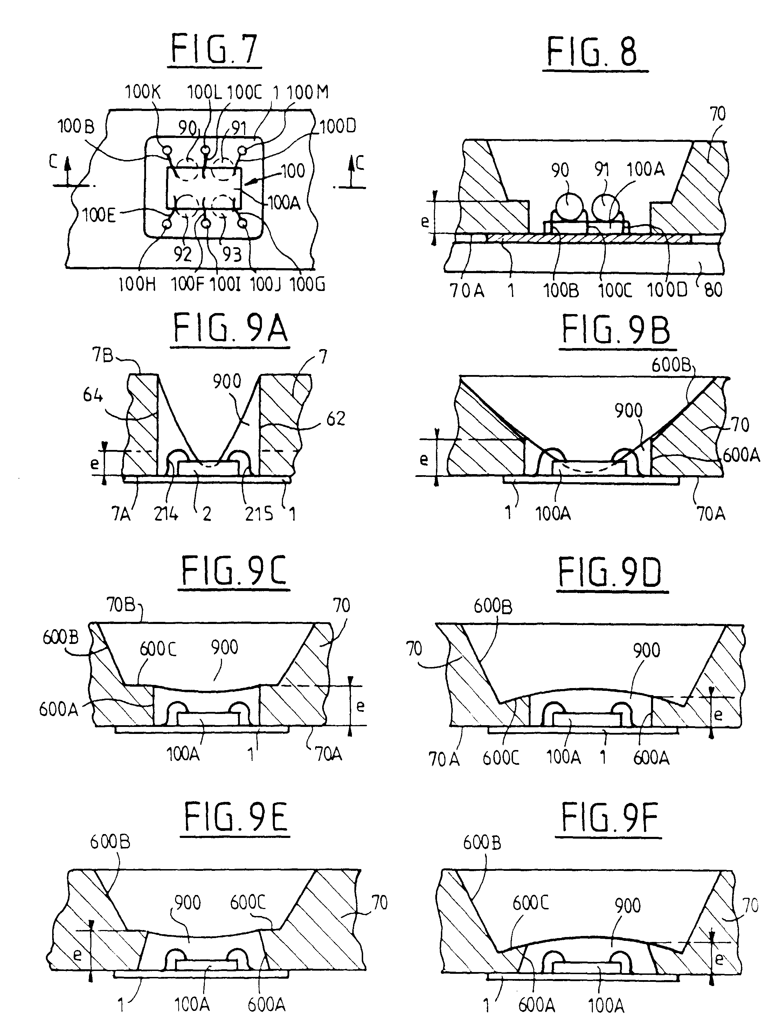

La figure 7 illustre, en vue de dessus, un mode préféré de mise en place du matériau d'enrobage, lorsque ce dernier possède, à température ambiante, au moment où il est placé à l'intérieur du cadre, un état intermédiaire entre l'état solide et l'état liquide. Pour passer à l'état liquide, il est nécessaire de monter en température, ce qui est par exemple le cas avec certaines résines époxydes qui polymérisent à une température de 150°C, en passant par une phase liquide à une température approximative de 50°C.

La figure 8 est une vue en coupe CC de la figure 7 montrant la répartition du matériau d'enrobage sur un plan vertical, avant qu'il soit passé par sa phase liquide.

Le procédé illustré par les figures 7 et 8 permet d'optimiser la répartition du matériau d'enrobage lorsqu'il passe en phase liquide, afin qu'il puisse se répartir le plus rapidement possible dans la totalité du volume délimité par le cadre et l'ensemble électronique. Conformément au procédé illustré par ces figures 7 et 8, on dispose à l'intérieur du cadre plusieurs gouttes 90, 91, 92, 93 de matériau d'enrobage dans un état semi-liquide, de sorte qu'une répartition correcte du matériau est assurée lorsqu'il passe à l'état liquide avant le durcissement.

Ainsi, à titre d'exemple, sur la figure 7, l'ensemble électronique 100 est constitué par le circuit intégré 100A et par six fils conducteurs 100B, C, D, E, F, G, et est placé sur le support 1, les fils conducteurs communicant par ailleurs avec l'autre face du support par l'intermédiaires de trous 100H, I, J, K, L, M. Les fils conducteurs, de même que les trous, sont répartis trois par trois de part et d'autre de deux côtés opposés du circuit intégré 100A, et les gouttes de matériau d'enrobage sont de préférence placées dans l'intervalle séparant deux fils conducteurs, de façon à ce que le matériau d'enrobage puisse bien diffuser autour des fils lorsqu'il passe à l'état liquide. Dans l'exemple, il faut donc disposer quatre gouttes de matériau d'enrobage.

De préférence, les gouttes sont de volume identique, de façon que le volume total des gouttes utilisées corresponde au volume final du matériau d'enrobage à placer dans le cadre.

La figure 8 illustre, en coupe verticale CC de la figure 7, la répartition du matériau d'enrobage avant qu'il passe à l'état liquide, lorsqu'il est disposé en plusieurs gouttes. Il est entendu que les proportions du dessin ne sont absolument pas respectées car, par exemple, pour la réalisation de circuits électroniques destinés à être intégrés dans des cartes à mémoire ou à microcircuit, l'ensemble électronique constitué par la mémoire ou les microcircuits incorporés dans la puce possède une épaisseur extrêmement réduite par rapport à ses autres dimensions. En effet, on le rappelle, la puce peut avoir une épaisseur de quelques microns, pour une longueur et une largeur de quelques millimètres. A titre d'exemple, une puce destinée à être incorporée dans une carte à mémoire ou à microcircuits peut avoir sa section comprise entre 10 et 30 millimètres carrés, ce qui correspond à des côtés de l'ordre de 5 millimètres, et son épaisseur peut atteindre 100 à 500 microns, d'où il en résulte que le volume total de la puce est de l'ordre de 5 millimètres cubes. Il en résulte que l'épaisseur de la puce est en moyenne 50 fois moins importante que ses autres dimensions, ce qui aurait été impossible à visualiser sur la figure. Il en est de même pour les dimensions du cadre constituant le rebord périphérique de l'enrobage qui, dans un tel cas, peut avoir ses dimensions parallèles au support de l'ordre de 7 millimètres chacune, ce qui correspond à une surface d'une cinquantaine de millimètres carrés, alors que sa hauteur ou son épaisseur doit être comprise entre 150 et 700 microns, c'est-à-dire qu'elle est en moyenne 20 fois moins importante.

Il en est de même pour le diamètre des gouttes du matériau d'enrobage disposées sur l'ensemble électronique 101 avant leur passage en phase liquide, puisqu'à titre d'exemple, pour un ensemble électronique de section carrée ayant par exemple 4 millimètres de côté, pour une épaisseur de 200 microns, que l'on veut enrober dans un volume ayant une section carrée de l'ordre de 7 millimètres et une épaisseur de 350 microns, il est nécessaire de disposer un volume de matériau d'enrobage de l'ordre de 13 millimètres cubes qui, s'il est réparti en 4 gouttes de volume égal, nécessite que chacune des gouttes ait un diamètre de l'ordre de 2 millimètres, c'est-à-dire un diamètre 5 fois plus important que l'épaisseur totale du cadre.

Ainsi, sur la figure 8, on aperçoit 2 des gouttes 90, 91 dans le cas où 4 gouttes sont disposées.

Les figures 9A, 9B, 9C, 9D illustrent l'importance qu'il convient d'accorder à la réalisation de la partie active du cadre, c'est-à-dire la partie déterminant la forme des côtés de l'enrobage adjacents au support.

La forme et les dimensions du cadre revêtent toute leur importance lorsque le produit d'enrobage est en phase liquide, puisque c'est à ce moment que la forme finale de l'enrobage se détermine.

La figure 9A illustre, selon une coupe AA de la figure 3, un dispositif dont la profondeur du cadre serait trop importante. Sur cette figure, on voit deux côtés opposés 62, 64 du cadre 6 ménagés dans la barrette 70. Par ailleurs, les côtés 62, 64 du cadre sont ménagés entre un rebord inférieur 7A de celui-ci et un rebord supérieur 7B opposé au rebord 7A. Le rebord 7A est celui qui est destiné à venir au contact du support 1 de l'ensemble électronique pendant la phase d'enrobage. Dans l'exemple illustré par cette figure 9A, la profondeur ou l'épaisseur du cadre, c'est-à-dire la distance de séparation entre l'angle commun au rebord 7B et aux côtés 62, 64 du cadre, et le plan passant par le rebord inférieur 7A est nettement supérieure à la profondeur "e" que devrait avoir l'enrobage. On constate qu'après avoir placé la quantité du matériau d'enrobage 900 qui permettrait d'obtenir le volume souhaité, en raison de la très faible section du cadre 6, le matériau d'enrobage, après être passé en phase liquide, remonte par capillarité le long des côtés 62, 64 du cadre, jusqu'à l'angle formé entre le bord supérieur 78 et lesdits côtés, formant ainsi un ménisque concave. Il en résulte qu'au centre du cadre, le niveau du matériau d'enrobage est nettement insuffisant, ce qui peut entraîner, comme illustré par cette figure 9A, un enrobage non total de l'ensemble électronique formé par le circuit intégré 2 et les fils de connexion non visibles sur cette figure.

La figure 9B illustre le cas où la barrette 70 dans laquelle est ménagée une ouverture 600 possède une épaisseur supérieure à l'épaisseur finale "e" que doit avoir l'enrobage et dans laquelle l'ouverture 600 est réalisée en deux parties, une première 600A ouverte sur la face 70A de la barrette destinée à venir au contact du support, ladite première partie 600A déterminant un cadre ayant une profondeur "e" et des dimensions correspondant à celles de l'enrobage final, et la seconde partie 600B ayant des parois inclinées, réalisant ainsi un évasement de l'ouverture en direction de la seconde face 708 de la barrette. Lesdites parois inclinées débouchent directement sur la première partie 600A, de sorte que l'intersection entre une paroi de la première partie 600A constituant le cadre et la paroi adjacente de la seconde partie 600B, délimitent un angle obtu : il peut arriver que par capillarité, comme illustré par cette figure 9B, le matériau d'enrobage 900, lorsqu'il est en phase liquide remonte le long des parois de la seconde partie 600B, et qu'on aboutisse à un mauvais enrobage ou un enrobage partiel de l'ensemble électronique constitué par le circuit intégré 100A et les fils de liaison.

Les figures 9C et 9D illustrent deux variantes qui permettent d'obtenir un enrobage sans les inconvénients illustrés en regard des figures 9A et 9B.

Sur la figure 9C, on a en fait représenté le dispositif décrit en regard de la figure 6 après que du matériau d'enrobage 900 y ait été placé et soit passé en phase liquide. La barrette 70 dans laquelle est ménagé le cadre déterminant la forme du rebord adjacent au support 1 ainsi que sa hauteur, possède une épaisseur globale nettement plus importante que l'épaisseur finale souhaitée pour l'enrobage, de sorte qu'il est nécessaire que la cavité 600 soit réalisée en au moins deux parties, une première partie 600A constituant le cadre, et débouchant directement sur une première face 70A de la barrette, destinée à venir au contact du support 1, et une seconde partie 600B partant de la première et souvrant sur une seconde face 70B de la barrette 70, opposée à sa première face 70A. En outre, il faut que la séparation entre les parois de chacune des deux parties soit marquée de manière nette pour que le produit d'enrobage 900, lorsqu'il est en phase liquide, n'ait pas tendance à remonter le long des parois de la seconde partie. C'est pourquoi, conformément à l'exemple illustré dans cette variante, on prévoit que le cadre 600A débouche dans la seconde partie, et est relié aux parois de celle-ci, par l'intermédiaire d'une bordure 600C qui est portée sur un plan parallèle à la première face 70A de la barrette et constitue un palier, comme illustré par la figure 9C, ou bien encore qui forme une pente descendante entre son intersection avec les côtés du cadre et son intersection avec les parois de la seconde partie 600B comme illustré par la figure 9D. Ainsi, en raison de l'existence des phénomènes de capillarité et des tensions superficielles, lorsque le produit d'enrobage est à l'état liquide, en aucun cas il ne pourra se répandre sur la bordure 600C ou le palier, mais il se stabilisera à l'intersection entre le bord supérieur du cadre 600A et la bordure 600C ou le palier entourant ledit cadre.

En raison des tolérances qui peuvent exister sur le volume du produit d'enrobage placé à l'intérieur du cadre, il peut arriver qu'il y ait soit juste la quantité nécessaire, soit un peu trop de produit, ou soit une quantité légèrement insuffisante. Dans le cas où la quantité est légèrement insuffisante, la face supérieure de l'enrobage prendra une forme de ménisque concave lorsque le produit sera en phase liquide, ledit ménisque prenant naissance à l'intersection entre les parois du cadre 600A et la bordure 600C ou le palier entourant ledit cadre, comme cela est illutré par la figure 9C. Par contre, si un peu trop de produit d'enrobage 900 est placé à l'intérieur du cadre 600A, alors il se formera un ménisque convexe prenant naissance également à l'intersection entre les côtés du cadre et la bordure 600C ou le palier périphérique, comme illustré par la figure 9D. Il faut cependant noter que l'on peut contrôler le volume de matériau d'enrobage à quelques centièmes de millimètre cube, au moment de sa mise en place, de sorte que la déformation due à la concavité ou à la convexité est négligeable. En effet, une erreur de dosage ou un dixième de millimètre cube en plus ou en moins correspond à une convexité ou à une concavité dont la hauteur ou profondeur est de l'ordre de deux microns, ce qui est négligeable par rapport à 350 microns, qui est la valeur moyenne de la hauteur de l'enrobage. Une telle convexité ou concavité est quasiment invisible, et sans aucune conséquence. On doit donc admettre que le procédé de l'invention permet un contrôle parfait de la forme et des dimensions de l'enrobage.

Sur les figures 9C et 9D, on a illustré des cas où les parois périphériques du cadre, déterminant la forme de l'enrobage sont perpendiculaires à la face 70A de la barrette destinée à être appliquée contre le support, de sorte qu'un enrobage réalisé à l'aide d'un tel dispositif aurait une base parallélépipèdique rectangle.

Les figures 9E et 9F illustrent respectivement des variantes des figures 9C et 9D dans lesquelles lesdites parois du cadre, c'est-à-dire de la première partie 600A de cavité sont légèrement inclinées, la section à la base étant supérieure à la section au débouché dans la seconde partie, de façon à faciliter le retrait de la barrette après le durcissement du produit d'enrobage.

Il faut enfin noter que les variantes illustrées par les figures 9D et 9F sont plus difficiles à mettre en oeuvre, car il faut rappeler que la hauteur "e" séparant le plan du support, de l'intersection entre les parois du cadre 600A et la bordure 600C ou le palier périphérique peut être très faible, de l'ordre de 300 microns, et il en résulte que l'usinage d'une bordure inclinée peut poser des problèmes particuliers de réalisation. Par ailleurs, de très bons résultats sont obtenus en mettant en oeuvre les variantes illustrés par les figures 9C ou 9E, sans qu'il soit forcément nécessaire de tenter de réaliser les variantes de figures 9D et 9F. On a simplement évoqué ces possibilités pour montrer l'importance qu'il y a à ce que l'ouverture du cadre opposée à celle destinée à venir au contact du support 1 soit entourée par une bordure dont la forme et la conception sont telles que le produit d'enrobage, lorsqu'il est en phase liquide, ne puisse pas se diffuser sur ce rebord, mais reste bien dans les limites du cadre, et ne puisse pas remonter, de façon à ce qu'une partie de l'ensemble électronique ne soit pas enrobée.

De préférence, le dispositif d'enrobage (barrette, moyens de chauffage) est complété par un dispositif de mise en place du volume nécessaire de matériau d'enrobage.

Dans le cas d'une barrette avec plusieurs cadres, on prévoit soit que les cadres sont remplis l'un après d'autre, le dispositif de mise en place se déplaçant relativement à la barrette, soit que le dispositif peut remplir simultanément tous les cadres d'une même barrette.

On comprend donc également, à la lecture de ce qui précède, qu'il est important pour la mise en oeuvre de l'invention que le dispositif soit placé d'une façon telle que le support se trouve sur un plan horizontal, avec l'ensemble électronique au-dessus du support, puisque la répartition du produit d'enrobage s'effectue lorsqu'il est dans un état liquide, en utilisant des phénomènes de gravité, de capillarité et en mettant à profit les tensions superficielles qui peuvent régner à la surface des liquides pour bien le répartir à l'intérieur du cadre.

L'invention est donc particulièrement avantageuse, simple à mettre en oeuvre, et résout totalement les problèmes de l'art antérieur, puisqu'elle permet d'obtenir un enrobage à la forme et aux dimensions souhaitées, dont la mise en place ne risque absolument pas de détériorer l'ensemble électronique qu'il est destiné à enrober.

## Revendications

1. Procédé pour enrober sur son support (1), à l'aide d'un matériau durcissable (900), un ensemble électronique formé d'un circuit intégré (2, 3, 4, 100...108, 100A) et de ses fils de contact (210 ... 215, 310 ... 315, 410 .... 415, 100B ... 100G) avec l'extérieur, et porté par une face dudit support (1), consistant d'une part à positionner le support (1) et l'ensemble électronique de façon que ladite face du support (1) portant le circuit intégré se trouve dans un plan sensiblement horizontal, à un niveau supérieur aux autres plans du support, la base de l'enrobage étant ainsi constituée sur le support, à positionner sur ladite face du support, autour de l'ensemble électronique,un dispositif d'enrobage définissant un orifice qui s'étend entre une première et une seconde faces opposées (70A,70B) de celui-ci et comprend une première partie constituant un cadre (6,600A,....608A) dont les dimensions et la forme correspondent aux dimensions et à la forme du bord extérieur de l'enrobage adjacent à ladite face du support, une première ouverture du cadre débouchant dans la première face (70A) du dispositif d'enrobage et la périphérie de cette ouverture étant plaquée sur le support, le cadre s'étendant à partir de cette première ouverture dans l'épaisseur du dispositif d'enrobage vers une seconde ouverture opposée à la première et par laquelle il est accessible et consistant d'autre part à mettre dans le cadre, par son ouverture accessible, la quantité nécessaire de matériau d'enrobage (900) pour obtenir l'enrobage final, ledit matériau étant choisi parmi ceux qui sont susceptibles de posséder un état liquide entre le moment où ils sont mis dans le cadre et avant leur durcissement, de sorte que, pendant qu'il est à l'état liquide, le matériau se répand par gravité dans la totalité du cadre, et épouse par capillarité la forme du rebord intérieur de celui-ci, l'enrobage prenant ainsi sa forme définitive avant durcissement, le matériau étant ensuite durci, et le cadre étant retiré après durcissement du matériau, caractérisé en ce que le cadre (6,600A,....608A) s'étend sur une partie seulement de l'épaisseur du dispositif d'enrobage et l'orifice comprend une seconde partie (600B,...,608B) qui s'étend à partir d'un palier (600C,....,608C) vers la seconde face (70B) du dispositif d'enrobage selon une section supérieure à celle de la première partie.

2. Procédé d'enrobage selon la revendication 1, caractérisé en ce qu'il consiste à déposer un matériau d'enrobage (900) sous forme liquide, ledit matériau étant choisi parmi ceux qui présentent la particularité de polymériser ou durcir à température ambiante.

3. Procédé d'enrobage selon la revendication 1, caractérisé en ce qu'il consiste à déposer un matériau d'enrobage liquide présentant la particularité d'être polymérisable ou durcissable, en le portant à une température déterminée supérieure à la température à laquelle il est mis en place, et à mettre en oeuvre des moyens pour porter le matériau d'enrobage (900) à sa température de polymérisation ou de durcissement.

4. Procédé d'enrobage selon la revendication 1, caractérisé en ce que le matériau d'enrobage est visqueux à la température ambiante à laquelle il est déposé, et présente la particularité de pouvoir être polymérisé suite à une élévation de température, en passant par une phase liquide entre la température ambiante et ladite température de polymérisation, et en ce qu'il consiste à mettre en oeuvre des moyens pour monter en température ledit matériau d'enrobage après qu'il ait été mis en place à l'intérieur du cadre.

5. Procédé d'enrobage selon la revendication 3 ou 4, caractérisé en ce qu'il consiste à déposer le matériau d'enrobage (900) en au noins deux emplacements distincts à l'intérieur du cadre, de façon à favoriser sa répartition sur l'ensemble électronique lorsqu'il passe à l'état liquide.

6. Procédé d'enrobage selon l'une quelconque des revendications précédentes, caractérisé en ce que le matériau d'enrobage (900) est choisi parmi les résines époxy.

7. Dispositif d'enrobage pour la mise en oeuvre du procédé selon l'une quelconque des revendications 1 à 6, dans lequel est ménagé au moins un orifice (6, 600 ... 608) débouchant sur lesdites première et seconde faces opposées (7A, 7B, 70A, 70B) ladite première face (7A, 70A) étant prévue pour venir au contact d'un support (1) d'au moins un ensemble électronique pendant l'enrobage, la partie au moins de chaque orifice ouverte sur ladite première face (7A, 70A) destinée à venir au contact du support constituant ledit cadre (6,600A,....608A) dont les dimensions et la forme correspondent aux dimensions et à la forme du bord extérieur de l'enrobage adjacent à ladite face du support, une première ouverture du cadre débouchant dans la première face (70A) du dispositif d'enrobage et la périphérie de cette ouverture étant plaquée sur le support, le cadre s'étendant à partir de cette première ouverture dans l'épaisseur du dispositif d'enrobage vers une seconde ouverture opposée à la première et par laquelle il est accessible sur une hauteur (e) égale à l'épaisseur souhaitée de l'enrobage, cette seconde ouverture étant entourée par ledit palier (600C,....,608C), les dimensions du cadre étant telles que celui-ci délimite un volume supérieur à celui d'un ensemble électronique à enrober, caractérisé en ce que le dispositif d'enrobage est une barrette comportant au moins ledit orifice , le nombre d'orifices correspondant au nombre d'ensembles à enrober simultanément, l'orifice comprenant une seconde partie (600B,...,608B) qui s'étend à partir du palier vers la seconde face (70B) de la barrette selon une section supérieure à celle de la première partie et telle qu'aucun des points du palier n'est à une distance orthogonale de la première face (70A) supérieure à la hauteur (e) du cadre.

8. Dispositif selon la revendication 7, caractérisé en ce que la barrette (7, 70) est réalisée dans un bloc unitaire de matériau.

9. Dispositif selon l'une des revendications 7 et 8, caractérisé en ce qu'il comporte un socle (80) avec une face plane (81), pour recevoir la face du support (1) d'au moins un ensemble électronique opposée à celle portant chaque ensemble, de façon que lorsque la barrette (70) est placée au-dessus du support (1), ce dernier se trouve serré entre le socle et la barrette, pour que le liquide d'enrobage ne puisse pas s'écouler entre la barrette et le support, et en ce que des moyens (71, 72, 82, 83, 84, 85, 109, 110) sont prévus pour positionner correctement le socle par rapport à la barrette, et le support (1) par rapport à la barrette, respectivement.

10. Dispositif selon l'une quelconque des revendications 7 à 9, caractérisé en ce que la barrette est constituée par un matériau conducteur thermique, et comporte, enfermés dans sa masse, des éléments chauffants (9) pour permettre le durcissement ou la polymérisation à chaud du matériau d'enrobage.

11. Dispositif selon l'une des revendications 7 à 9, caractérisé en ce que la barrette est constituée dans un matériau conducteur thermique tel qu'un matériau à base de métal, pour autoriser le durcissement ou la polymérisation à température ambiante du matériau d'enrobage, ou un durcissement ou une polvmérisation à chaud par chauffage de la barrette, au moins, à l'aide d'une source de chauffage appropriée.

12. Dispositif selon l'une quelconque des revendications 7 à 9, caractérisé en ce que la barrette (7, 70) est constituée dans un matériau isolant de la chaleur, tel qu'une céramique, afin d'autoriser le durcissement ou la polymérisation à température ambiante du matériau d'enrobage, ou un durcissement ou une polymérisation à chaud par exposition directe du matériau d'enrobage à une source de rayonnement appropriée.

13. Dispositif selon l'une des revendications 10 à 12, caractérisé en ce qu'il comporte au moins une source de rayonnement extérieure, placée de façon telle que le matériau d'enrobage et/ou la barrette peuvent y être exposés directement, de façon que le matériau d'enrobage soit porté à sa température de durcissement ou de polymérisation.

## Patentansprüche

1. Verfahren zur Einkapselung einer Elektronikgruppe auf ihrem Träger (1), die aus einer integrierten Schaltung (2, 3, 4, 100...108, 100A) und ihren Kontaktdrähten (210 ... 215, 310 ... 315, 410 ... 415, 100B ... 100 G) nach außen gebildet ist und von einer Seite des Trägers (1) getragen wird, mit Hilfe eines aushärtbaren Materials (900), das einerseits darin besteht, den Träger (1) und die Elektronikgruppe derart zu positionieren, daß sich die Seite des Trägers (1), die die integrierte Schaltung trägt, in einer im wesentlichen horizontalen Ebene auf einer Höhe über den anderen Ebenen des Trägers befindet, wobei die Einkapselungsbasis also auf dem Träger gebildet ist, auf der Seite des Trägers um die Elektronikgruppe eine Einkapselungsvorrichtung zu positionieren, die eine Öffnung bildet, die sich zwischen einer ersten und einer zweiten, gegenüberliegenden Seite (70A, 70B) davon erstreckt und einen ersten Teil aufweist, der einen Rahmen (6, 600A, ... 608A) bildet, dessen Abmessungen und Form den Abmessungen und der Form des Außenrandes der Einkapselung angrenzend an die Seite des Trägers entsprechen, wobei eine erste Öffnung des Rahmens in die erste Seite (70A) der Einkapselungsvorrichtung mündet und der Umfang dieser Öffnung auf dem Träger aufliegt, wobei sich der Rahmen ausgehend von dieser ersten Öffnung in der Dicke der Einkapselungsvorrichtung zu einer zweiten, der ersten gegenüberliegenden Öffnung erstreckt, durch die er zugänglich ist, und das andererseits darin besteht, in dem Rahmen durch seine zugängliche Öffnung die erforderliche Menge an Einkapselungsmaterial (900) vorzusehen, um die endgültige Einkapselung zu erhalten, wobei das Material aus denjenigen ausgewählt ist, die zwischen dem Zeitpunkt, an dem sie in den Rahmen eingebracht werden, und vor ihrem Aushärten einen flüssigen Zustand besitzen können, so daß sich das Material, während es im flüssigen Zustand ist, durch Schwerkraft im gesamten Rahmen ausbreitet und durch Kapillarwirkung an die Form seines inneren Randes anpaßt, wobei die Einkapselung dann vor dem Aushärten ihre endgültige Form annimmt, wobei das Material dann ausgehärtet wird und der Rahmen nach dem Aushärten des Materials abgezogen wird, dadurch gekennzeichnet, daß sich der Rahmen (6,600A,....608A) nur über einen Teil der Dicke der Einkapselungsvorrichtung erstreckt und die Öffnung einen zweiten Teil (600B,...,608B) aufweist, der sich ausgehend von einem Absatz (600C,....,608C) zu der zweiten Seite (70B) der Einkapselungsvorrichtung nach einem größeren Querschnitt als demjenigen des ersten Teils erstreckt.

2. Einkapselungsverfahren nach Anspruch 1, dadurch gekennzeichnet, daß es darin besteht, ein Einkapselungsmaterial (900) in flüssiger Form aufzubringen, wobei das Material aus denjenigen ausgewählt ist, die die Besonderheit aufweisen, bei Umgebungstemperatur zu polymerisieren oder auszuhärten.

3. Einkapselungsverfahren nach Anspruch 1, dadurch gekennzeichnet, daß es darin besteht, ein flüssiges Einkapselungsmaterial aufzubringen, das die Besonderheit aufweist, polymerisierbar oder aushärtbar zu sein, indem es auf eine bestimmte Temperatur über der Temperatur gebracht wird, bei der es eingebracht wird, und Mittel zu verwenden, um das Einkapselungsmaterial (900) auf seine Polymerisations- oder Aushärtungstemperatur zu bringen.

4. Einkapselungsverfahren nach Anspruch 1, dadurch gekennzeichnet, daß das Einkapselungsmaterial bei der Umgebungstemperatur, bei der es aufgebracht wird, viskos ist und die Besonderheit aufweist, daß es nach einer Temperaturerhöhung polymerisiert werden kann, wobei ein Übergang über eine flüssige Phase zwischen der Umgebungstemperatur und der Polymerisationstemperatur stattfindet, und daß es darin besteht, Mittel zu verwenden, um die Temperatur des Einkapselungsmaterials zu erhöhen, nachdem es innerhalb des Rahmens eingebracht wurde.

5. Einkapselungsverfahren nach Anspruch 3 oder 4, dadurch gekennzeichnet, daß es darin besteht, das Einkapselungsmaterial (900) an wenigstens zwei verschiedenen Stellen im Inneren des Rahmens aufzubringen, so daß seine Verteilung auf der Elektronikgruppe gefördert wird, wenn es in den flüssigen Zustand übergeht.

6. Einkapselungsverfahren nach einem der vorhergehenden Ansprüche, dadurch gekennzeichnet, daß das Einkapselungsmaterial (900) aus den Epoxidharzen ausgewählt ist.

7. Einkapselungsvorrichtung zur Durchführung des Verfahrens nach einem der Ansprüche 1 bis 6, in der eine Öffnung (6, 600 ... 608) vorgesehen ist, die an der ersten und der zweiten gegenüberliegenden Seite (7A, 7B, 70A, 70B) mündet, wobei die erste Seite (7A, 70A) vorgesehen ist, um während der Einkapselung mit einem Träger (1) wenigstens einer Elektronikgruppe in Kontakt zu gelangen, wobei der wenigstens eine Teil jeder Öffnung, der zu der ersten Seite (7A, 70A) offen ist und dazu bestimmt ist, mit dem Träger in Kontakt zu gelangen, den Rahmen (6,600A,....608A) bildet, dessen Abmessungen und Form den Abmessungen und der Form des Außenrandes der Einkapselung angrenzend an die Seite des Trägers entsprechen, wobei eine erste Öffnung des Rahmens in die erste Seite (70A) der Einkapselungsvorrichtung mündet und der Umfang dieser Öffnung auf dem Träger aufliegt, wobei sich der Rahmen ausgehend von dieser ersten Öffnung in der Dicke der Einkapselungsvorrichtung zu einer zweiten, der ersten gegenüberliegenden Öffnung erstreckt, durch die er auf einer Höhe (e) gleich der gewünschten Dicke der Einkapselung zugänglich ist, wobei diese zweite Öffnung von dem Absatz (600C,....,608C) umgeben ist, wobei die Abmessungen des Rahmens derart sind, daß dieser ein größeres Volumen als dasjenige einer einzukapselnden Elektronikgruppe abgrenzt, dadurch gekennzeichnet, daß die Einkapselungsvorrichtung eine Zeile ist, die wenigstens die Öffnung aufweist, wobei die Anzahl von Öffnungen zahlenmäßig den gleichzeitig einzukapselnden Gruppen entspricht, wobei die Öffnung einen zweiten Teil (600B,...,608B) aufweist, der sich ausgehend von dem Absatz zu der zweiten Seite (70B) der Zeile nach einem größeren Querschnitt als demjenigen des ersten Teils erstreckt, und nach einem solchen, daß kein Punkt des Absatzes in einem orthogonalen Abstand von der ersten Seite (70A) über der Höhe (e) des Rahmens liegt.

8. Vorrichtung nach Anspruch 7, dadurch gekennzeichnet, daß die Zeile (7, 70) in einem einheitlichen Materialblock hergestellt ist.

9. Vorrichtung nach einem der Ansprüche 7 und 8, dadurch gekennzeichnet, daß sie einen Sockel (80) mit einer ebenen Seite (81) aufweist, um die Seite des Trägers (1) wenigstens einer Elektronikgruppe aufzunehmen, die der jede Gruppe tragenden gegenüberliegt, so daß dann, wenn die Zeile (70) über dem Träger (1) angeordnet ist, dieser zwischen dem Sockel und der Zeile eingeklemmt ist, damit die Einkapselungsflüssigkeit nicht zwischen der Zeile und dem Träger auslaufen kann, und daß Mittel (71, 72, 82, 83, 84, 85, 109, 110) vorgesehen sind, um den Sokkel bezüglich der Zeile bzw. den Träger (1) bezüglich der Zeile korrekt zu positionieren.

10. Vorrichtung nach einem der Ansprüche 7 bis 9, dadurch gekennzeichnet, daß die Zeile aus einem wärmeleitenden Material besteht und, in ihrer Masse eingeschlossen, Heizelemente (9) aufweist, um die Aushärtung und Warmpolymerisation des Einkapselungsmaterials zu ermöglichen.

11. Vorrichtung nach einem der Ansprüche 7 bis 9, dadurch gekennzeichnet, daß die Zeile aus einem wärmeleitenden Material wie einem Material auf Metallbasis besteht, um die Aushärtung oder Polymerisation des Einkapselungsmaterials bei Umgebungstemperatur oder wenigstens mit Hilfe einer geeigneten Heizquelle eine Aushärtung oder Warmpolymerisation durch Erwärmung der Zeile zuzulassen.

12. Vorrichtung nach einem der Ansprüche 7 bis 9, dadurch gekennzeichnet, daß die Zeile (7, 70) aus einem wärmeisolierenden Material wie einer Keramik besteht, um die Aushärtung oder Polymerisation des Einkapselungsmaterials bei Umgebungstemperatur oder eine Aushärung oder Warmpolymerisation durch direktes Aussetzen des Einkapselungsmaterial an eine geeignete Strahlungsquelle zuzulassen.

13. Vorrichtung nach einem der Ansprüche 10 bis 12, dadurch gekennzeichnet, daß sie wenigstens eine äußere Strahlungsquelle aufweist, die derart angeordnet ist, daß ihr das Einkapselungsmaterial und/oder die Zeile direkt ausgesetzt werden kann, so daß das Einkapselungsmaterial auf seine Aushärtungs- oder Polymerisationstemperatur gebracht wird.

## Claims

1. Method for coating, on its support (1), with the aid of a hardenable material (900), an electronic assembly consisting of an integrated circuit (2, 3, 4, 100 ... 108, 100A) and its wires (210 ... 215, 310 ... 315, 410 ... 415, 100B ... 100G) providing contact with the exterior, and mounted on one face of said support (1), consisting on the one hand in positioning the support (1) and the electronic assembly in such a way that said face of the support (1) bearing the integrated circuit is in a substantially horizontal plane, at a higher level than the other planes of the support, the base for the coating thus being formed on the support, in positioning on said face of the support, around the electronic assembly, a coating device defining an orifice that extends between a first and a second opposite faces (70A, 70B) thereof and comprises a first part that constitutes a frame (6, 600A, ... 608A), the dimensions and shape of which correspond to the dimensions and shape of the external edge of the coating adjacent to said face of the support, a first opening in the frame opening out on the first face (70A) of the coating device and the periphery of this opening being pressed against the support, the frame extending from this first opening in the thickness of the coating device to a second opening opposite the first and through which it is accessible, and consisting on the other hand in putting into the frame, through its accessible opening, the quantity of coating material (900) necessary to obtain a final coating, said material being chosen from those which are capable of processing a liquid state from the moment when they are put into the frame and before their hardening, so that, while it is in the liquid state, the material spreads through gravity over the whole frame, and takes on by capillarity the shape of the interior rim thereof, the coating taking in this way its final shape before hardening, the material then being hardened, and the frame being removed after hardening of the material, characterised in that the frame (6, 600A, ... 608A) extends over only one part of the thickness of the coating device and the orifice comprises a second part (600B, ..., 608B), which extends from one bearing surface (600C, ..., 608C) to the second face (70B) of the coating device along a section greater than that of the first part.

2. Coating method according to Claim 1, characterised in that it consists in depositing a coating material (900) in liquid form, said material being chosen from among those which have the characteristic of polymerising or hardening at ambient temperature.

3. Coating method according to Claim 1, characterised in that it consists in depositing a liquid coating material having the characteristic feature of being polymerisable or hardenable, while bringing it to a predetermined temperature higher than the temperature at which it is put into place, and in using means for bringing the coating material (900) to its polymerisation or hardening temperature.

4. Coating method according to Claim 1, characterised in that the coating material is viscous at the ambient temperature at which it is deposited and has the characteristic of being polymerisable after a rise in temperature, while passing through a liquid phase between the ambient temperature and said polymerisation temperature, and in that it consists in using means for raising the temperature of said coating material after it has been placed inside the frame.

5. Coating method according to Claim 3 or 4, characterised in that it consists in depositing the coating material (900) in at least two distinct locations within the frame so as to encourage its distribution over the electronic assembly when it passes to the liquid state.

6. Coating method according to any one of the preceding claims, characterised in that the coating material (900) is chosen from among the epoxy resins.

7. Coating device for implementing the method according to any one of Claims 1 to 6, in which an orifice (6, 600 ... 608) is made opening out on said first and second opposite faces (7A, 7B, 70A, 70B), said first face (7A, 70A) being intended to come into contact with a support (1) of at least one electronic assembly during coating, at least part of each orifice made in said first face (7A, 70A) intended to come into contact with the support constituting said frame (6, 600A, ... 608A), the dimensions and shape of which correspond to the dimensions and shape of the external edge of the coating adjacent to said face of the support, a first opening in the frame opening out on the first face (70A) of the coating device and the periphery of this opening being pressed against the support, the frame extending from this first opening in the thickness of the coating device to a second opening opposite the first and through which it is accessible over a height (e) equal to the desired thickness of the coating, this second opening being surrounded by said bearing surface (600C, ... 608C), the dimensions of the frame being such that it delimits a volume greater than that of an electronic assembly that is to be coated, characterised in that the coating device is a bar comprising at least said orifice, the number of orifices corresponding to the number of assemblies to be simultaneously coated, the orifice comprising a second part (600B, ..., 608B), which extends from the bearing surface to the second face (70B) of the bar along a section greater than that of the first part and such that none of the points on the bearing surface is at an orthogonal distance from the first face (70A) greater than the height (e) of the frame.

8. Device according to Claim 7, characterised in that the bar (7, 70) is made of a single block of material.

9. Device according to Claims 7 and 8, characterised in that it comprises a baseplate (80) with a flat face (81) for receiving the face of the support (1) of at least one electronic assembly opposite that carrying each assembly, so that when the bar (70) is placed above the support (1), the latter will be clamped between the baseplate and the bar, so that the coating liquid cannot run out between the bar and the support, and in that means (71, 72, 82, 83, 84, 85, 109, 110) are provided for positioning the baseplate correctly in relation to the bar, and the support (1) in relation to the bar, respectively.

10. Device according to any one of Claims 7 to 9, characterised in that the bar is made from a thermal conducting material and includes, enclosed within its mass, heating elements (9) to permit heat hardening or polymerisation of the coating material.

11. Device according to one of Claims 7 to 9, characterised in that the bar is made from a thermal conducting material such as a metal-based material, in order to allow the hardening or polymerisation at ambient temperature of the coating material, or a heat hardening or polymerisation by heating the bar, at least, with the aid of an appropriate heat source.

12. Device according to any one of Claims 7 to 9, characterised in that the bar (7,70) is made from a heat-insulating material, such as a ceramic, in order to allow the hardening or polymerisation at ambient temperature of the coating material, or heat hardening or polymerisation by direct exposure of the coating material to an appropriate source of radiation.

13. Device according to one of Claims 10 to 12, characterised in that it comprises at least one external source of radiation, placed in such a way that the coating material and/or the bar can be directly exposed thereto, so that the coating material can be brought to its hardening or polymerisation temperature.
